# EUROPEAN PATENT APPLICATION

(11) **EP 4 325 586 A1**
(43) Date of publication of application: **21.02.2024**
(21) Application number: 23191233.8
(22) Date of filing: 14.08.2023
(51) Int. Cl.: H01L 31/078, H01L 31/0745, H10K 30/57, H10K 30/10

(54) **A SOLAR BATTERY**

(30) Priority: 17.08.2022 CN 202210991928
(71) Applicant: Trina Solar Co., Ltd, 213001 Changzhou Jiangsu (CN); Nanjing University, Nanjing, Jiangsu 210023 (CN)
(72) Inventor: TAN, Hairen, Nanjing City, Jiangsu Province, 210023 (CN); XIA, Rui, Nanjing City, Jiangsu Province, 210023 (CN); LI, Hongjiang, Nanjing City, Jiangsu Province, 210023 (CN); LUO, Haowen, Nanjing City, Jiangsu Province, 210023 (CN); ZHANG, Xueling, Nanjing City, Jiangsu Province, 210023 (CN); XU, Guanchao, Nanjing City, Jiangsu Province, 210023 (CN); CHEN, Yifeng, Nanjing City, Jiangsu Province, 210023 (CN)
(74) Representative: Winter, Brandl - Partnerschaft mbB

(57) **Abstract**

The present disclosure relates to a solar battery including a first cell, and a second cell, and a first charge transport layer, a transparent conductive layer, a second charge transport layer and a polysilicon layer are disposed between the first photoelectric conversion layer of the first cell and the second photoelectric conversion layer of the second cell, and the second charge transport layer is disposed between the polysilicon layer and the transparent conductive layer, and the charge transport property of the second charge transport layer is the same as that of the polysilicon layer. In the solar battery of the present disclosure, a first charge transport layer, a transparent conductive layer, a second charge transport layer and a polysilicon layer are sequentially arranged between the first photoelectric conversion layer and the second photoelectric conversion layer. Especially the second charge transport layer may protect the polysilicon layer, may effectively transport the same type of charges, and avoid recombination phenomena at the interface or inside the film, thereby effectively improving the efficiency of the battery. The solar battery of this disclosure also has the characteristics of simple structure, simple and convenient manufacturing process, and low cost.

## Description

### FIELD OF THE INVENTION

The present disclosure relates to a solar battery.

### BACKGROUND OF THE INVENTION

Solar battery has been widely used as clean energy. Especially as carbon neutrality, energy saving and emission reduction have become the mainstream trend of the international community, photovoltaic power generation, as an important part of clean new energy, has gained more and more attention. However, the light utilization efficiency of current solar battery has not yet reached an ideal state, and it is still necessary to rationally design the structure of the solar battery to improve the cell efficiency.

### SUMMARY OF THE INVENTION

In order to overcome the above technical problems, the present disclosure provides a tandem solar battery comprising:
a first cell comprising a first photoelectric conversion layer comprising a first photoelectric conversion material having a first bandgap,
a second cell comprising a second photoelectric conversion layer comprising a second photoelectric conversion material having a second bandgap, wherein the first bandgap is not equal to the second bandgap;
a first charge transport layer, a transparent conductive layer, a second charge transport layer and a polysilicon layer are sequentially arranged between the first photoelectric conversion layer and the second photoelectric conversion layer,
wherein the second charge transport layer is disposed between the polysilicon layer and the transparent conductive layer, and the charge transport property of the second charge transport layer is the same as that of the polysilicon layer.

In the solar battery of the present disclosure, a first charge transport layer, a transparent conductive layer, a second charge transport layer and a polysilicon layer are sequentially arranged between the first photoelectric conversion layer and the second photoelectric conversion layer. Especially the second charge transport layer may protect the polysilicon layer, may effectively transport the same type of charges, and avoid recombination phenomena at the interface or inside the film, thereby effectively improving the efficiency of the battery. The solar battery of this disclosure also has the characteristics of simple structure, simple and convenient manufacturing process, and low cost.

In an embodiment, the polysilicon layer is p-type polysilicon, and has a thickness of 1 nm to 100 µm; and
the constituent material in the second charge transport layer is a p-type charge transport material with a thickness of 0.1-100 nm; preferably, the p-type charge transport material is selected from the group consisting of NiOx (where x is between 0.1 and 10), CuFeO₂, CuAlO₂, CuSCN, Cu₂O, WO₃, CuI₂, MoS₂, FeS₂, P₃HT, Spiro-meoTAD, Poly-TBD, PFN, PEDOT:PSS, PTAA and Spiro-TTB.

In an embodiment, the constituent material in the first charge transport layer is an n-type charge transport material; preferably, the n-type charge transport material is selected from the group consisting of TiO₂, SnO₂, ZnO, ZrO₂, In₂O₃, CdS, CdSe, BaSnO₃, Nb₂O₅, C60 and PCBM.

In an embodiment, the polysilicon layer is n-type polysilicon, and has a thickness of 1 nm to 100 µm; and
the constituent material in the second charge transport layer is an n-type charge transport material with a thickness of 0.1-100 nm; preferably, the n-type charge transport material is selected from the group consisting of TiO₂, SnO₂, ZnO, ZrO₂, In₂O₃, CdS, CdSe, BaSnO₃, Nb₂O₅, C60 and PCBM.

In an embodiment, the constituent material in the first charge transport layer is a p-type charge transport material; preferably, the p-type charge transport material is selected from the group consisting of NiOx (where x is between 0.1 and 10), CuFeO₂, CuAlO₂, CuSCN, Cu₂O, WO₃, CuI₂, MoS₂, FeS₂, P₃HT, Spiro-meoTAD, Poly-TBD, PFN, PEDOT:PSS, PTAA, and Spiro-TTB.

In an embodiment, the first charge transport layer has a thickness of 1-500 nm.

In an embodiment, the thickness of the first charge transport layer is greater than the thickness of the second charge transport layer.

In an embodiment, the second charge transport layer is attached to the surface of the polysilicon layer away from the second photoelectric conversion layer, and is located on the polysilicon layer; and
the transparent conductive layer is attached to the surface of the second charge transport layer away from the second photoelectric conversion layer, and is located on the second charge transport layer.

In an embodiment, the transparent conductive layer has a thickness of 1-1000 nm, and the material of the transparent conductive layer is selected from the group consisting of TiO₂, SnO₂, ZnO, ZrO₂, GZO, AZO, IZO, FTO, ITO, BaSnO₃, Ti-doped SnO₂, and Zn-doped SnO₂.

In an embodiment, the first photoelectric conversion material is selected from the group consisting of a perovskite, an amorphous silicon, GaInP, CdTe, a copper indium gallium selenide; preferably, the first photoelectric conversion material is a perovskite material with a band gap of 1.40 - 2.3 eV. Preferably, the first photoelectric conversion layer has a thickness of 1-5000 nm.

The second photoelectric conversion material is selected from the group consisting of a single crystal silicon, a polycrystalline silicon, GaAs, CdTe, and a perovskite; preferably, the second photoelectric conversion material is single crystal silicon.

In an embodiment, the solar battery comprises the following stacked layers from a light- incident surface:
a top metal electrode,
a top transparent conductive layer,
a third charge transport layer,
the first photoelectric conversion layer,
the first charge transport layer,
the transparent conductive layer,
the second charge transport layer,
the polysilicon layer,
a tunneling layer,
the second photoelectric conversion layer,
a passivation layer, and
a bottom metal electrode;
wherein the constituent material of the third charge transport layer has the same charge transport property as the constituent material of the second charge transport layer.

In an embodiment, the third charge transport layer has a thickness of 1-500 nm, which is greater than that of the second charge transport layer.

In an embodiment, the first photoelectric conversion layer has a thickness of 1 00-1000 nm; and the first photoelectric conversion material is perovskite with a band gap of 1 .40-2.3 eV; and
the second photoelectric conversion layer has a thickness of 1-200 µm; and the second photoelectric conversion material is an n-type single crystal silicon.

In an embodiment, the perovskite has a three-dimensional ABX₃ structure, wherein

A is selected from the group consisting of CH(NH₂)₂⁺, CH₃NH₃⁺, C(NH₂ )₃⁺, Cs⁺ and Rb⁺,
B is selected from the group consisting of Pb²⁺, Sn²⁺ and Sr²⁺, and
X is selected from the group consisting of Br⁻, I⁻ and Cl⁻.

In an embodiment, the top transparent conductive layer has a thickness of 0.1-1000 nm, the transparent conductive layer has a thickness of 0.1-1000 nm, and the constituent material of the top transparent conductive layer and the transparent conductive layer is independently selected from the group consisting of TiO₂, SnO₂, ZnO, ZrO₂, GZO, AZO, IZO, FTO, ITO, BaSnO₃, Ti-doped SnO₂, and Zn-doped SnO₂;
the top metal electrode and the bottom metal electrode layer includes one or a combination of at least two of Au, Ag, Al or Cu;
the third charge transport layer has a thickness of 1-500 nm, the second charge transport layer has a thickness of 1-100 nm, and the constituent material of the third charge transport layer and the second charge transport layer is independently selected from the group consisting of TiO₂, SnO₂, ZnO, ZrO₂, In₂O₃, CdS, CdSe, BaSnO₃, Nb₂O₅, C60, and PCBM;
the first charge transport layer has a thickness of 1-500 nm, and the constituent material is selected from the group consisting of NiOx (where x is between 0.1 and 10), CuFeO₂, CuAlO₂, CuSCN, Cu₂O, WO₃, CuI₂, MoS₂, FeS₂, P₃HT, Spiro-meoTAD, Poly-TBD, PFN, PEDOT:PSS, PTAA, and Spiro-TTB;
the polysilicon layer has a thickness of 1 nm to 100 µm, and the material is an n-type polysilicon;
the passivation layer has a thickness of 0.1-500 µm, and the material includes one or a combination of at least two of SiO₂, silicon nitride, aluminum oxide or silicon oxynitride; and
the tunneling layer has a thickness of 0.1 - 100 nm.

The present disclosure also provides a method of preparing a solar battery, comprising:
forming a second cell comprising a second photoelectric conversion layer comprising a second photoelectric conversion material having a second bandgap;
sequentially forming a polysilicon layer, a second charge transport layer, a transparent conductive layer and a first charge transport layer on the second photoelectric conversion layer;
forming a first cell comprising a first photoelectric conversion layer comprising a first photoelectric conversion material having a first bandgap; wherein the first bandgap is not equal to the second bandgap;
wherein the second charge transport layer is formed by a thermal evaporation, an atomic layer deposition, a plasma rapid deposition or a solution process.

In an embodiment, the transparent conductive layer is formed by a physical vapor deposition.

### BRIEF DESCRIPTION OF THE FIGURES

FIG. 1 shows a schematic structural view of an embodiment of a solar battery of the present disclosure.
FIG. 2 shows the current density-voltage curves of the solar batteries obtained in Example 1 and Comparative Example 1.

### DETAILED DESCRIPTION OF THE INVENTION

The present disclosure will be further described in detail through the figures and embodiments below. Through these descriptions, the features and advantages of the present disclosure will become clearer and more specific.

The wording "exemplary" is used exclusively herein to mean "serving as an example, embodiment, or illustration." Any embodiment described herein as "exemplary" is not necessarily to be construed as superior or better than other embodiments. While various aspects of the embodiments are shown in drawings, the drawings are not necessarily drawn to scale unless specifically indicated.

In addition, the technical features involved in different embodiments of the present disclosure described below may be combined with each other as long as they do not constitute a conflict with each other.

This disclosure provides a solar battery comprising:
a first cell comprising a first photoelectric conversion layer comprising a first photoelectric conversion material having a first bandgap,
a second cell comprising a second photoelectric conversion layer comprising a second photoelectric conversion material having a second bandgap, wherein the first bandgap is not equal to the second bandgap;
a first charge transport layer, a transparent conductive layer, a second charge transport layer and a polysilicon layer are sequentially arranged between the first photoelectric conversion layer and the second photoelectric conversion layer,
wherein the second charge transport layer is disposed between the polysilicon layer and the transparent conductive layer, and the charge transport property of the second charge transport layer is the same as that of the polysilicon layer.

The first charge transport layer may be disposed between the p first photoelectric conversion layer and the transparent conductive layer, and the charge transport property of the first charge transport layer is opposite to that of the second charge transport layer.

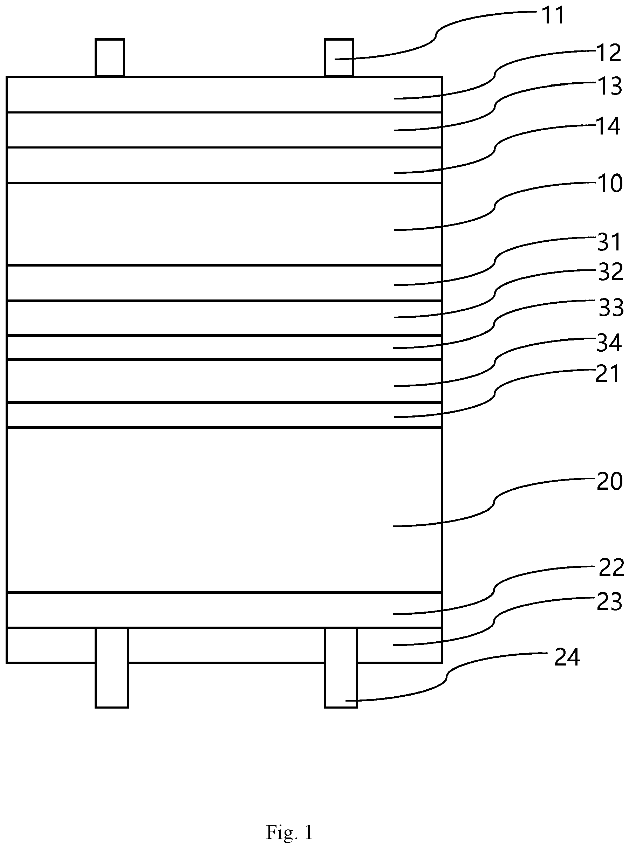

FIG. 1 shows an embodiment of the solar battery of the present disclosure. The solar battery of the present disclosure is further described below with reference to FIG. 1.

The solar battery of the present disclosure has a laminated structure, including a first cell and a second cell, and an intermediate structure between the photoelectric conversion layers of the first cell and the second cell.

The first cell comprises a first photoelectric conversion layer 10 comprising a first photoelectric conversion material having a first bandgap. The second cell comprises a second photoelectric conversion layer 20 comprising a second photoelectric conversion material having a second bandgap. The first cell is located above the second cell such that the first photoelectric conversion layer 10 is located above the second photoelectric conversion layer 20. In an embodiment, the first bandgap of the first photoelectric conversion material may be larger than the second bandgap of the second photoelectric conversion material. Of course, the first bandgap of the first photoelectric conversion material may be smaller than the second bandgap of the second photoelectric conversion material. However, the first way is preferably adopted, that is, the first bandgap of the first photoelectric conversion material is larger than the second bandgap of the second photoelectric conversion material.

In an embodiment, the first photoelectric conversion material can be selected from the group consisting of a perovskite, an amorphous silicon, GaInP, CdTe, and copper indium gallium selenide thin film. Preferably, the first photoelectric conversion material is a perovskite material.

In an embodiment, the second photoelectric conversion material may be selected from the group consisting of a single crystal silicon, a polycrystalline silicon, GaAs, CdTe, and a perovskite. Preferably, the second photoelectric conversion material is a single crystal silicon. The second photoelectric conversion layer may have a thickness of 1-500 µm, such as 1-200 µm.

For this disclosure, the perovskite may have a three-dimensional ABX₃ structure, wherein A is selected from the group consisting of CH(NH₂)₂⁺, CH₃NH₃⁺, C(NH₂ )₃⁺, Cs⁺ and Rb⁺; B is selected from the group consisting of Pb²⁺, Sn²⁺ and Sr²⁺, and X is selected from the group consisting of Br⁻, I⁻ and Cl⁻. The perovskite may have a bandgap of 1.40-2.3 eV. The perovskite layer composed of the perovskite material may have a thickness of 1-5000 nm. For example, the perovskite layer may have a thickness of 100-1000 nm, for example, 100 nm, 200 nm, 300 nm, 400 nm, 500 nm, 600 nm, 700nm, 800nm, 900nm or 1000nm.

The intermediate structure between the photoelectric conversion layer 10 of the first cell and photoelectric conversion layer 20 of the second cell at least comprises: a first charge transport layer 31, a transparent conductive layer 32, a second charge transport layer 33 and a polysilicon layer 34. In particular, in the embodiment where the first photoelectric conversion material is a perovskite material and the second photoelectric conversion material is a single crystal silicon, the first charge transport layer 31, the transparent conductive layer 32, the second charge transport layer 33 and a polysilicon layer 34 may be arranged sequentially from top to bottom (with the incident light surface as the top).

The first charge transport layer 31, the transparent conductive layer 32, the second charge transport layer 33 and the polysilicon layer 34 are respectively described below.

In an embodiment, the polysilicon layer 34 is a layer of an n-type polysilicon with a thickness of 1 nm to 100 µm. In an embodiment, the polysilicon layer 34 is a layer of a p-type polysilicon with a thickness of 1 nm to 100 µm. The polysilicon layer may be formed by a low pressure chemical vapor deposition (LPCVD) or a plasma enhanced chemical vapor deposition (PECVD).

In this disclosure, the second charge transport layer 33 is disposed between the polysilicon layer 34 and the transparent conductive layer 32, and the second charge transport layer 33 has a thickness smaller than that of the transparent conductive layer 32. The second charge transport layer 33 has the same charge transport properties as that of the polysilicon layer 34. The first charge transport layer 31 is disposed between the first photoelectric conversion layer 10 and the transparent conductive layer 32, and the first charge transport layer 31 has a charge transport property opposite to that of the second charge transport layer 33.

In an embodiment, the second charge transport layer 33 is attached to the surface of the polysilicon layer 34 away from the second photoelectric conversion layer 20, and is located on the polysilicon layer 34. When forming the second charge transport layer 33 on the polysilicon layer 34, in order to avoid the damage to the polysilicon layer, the second charge transport layer 33 can be prepared by a relatively mild process. In the present disclosure, the second charge transport layer 33 may have a thickness of 0.1-100 nm, such as 1-50 nm, or 1-20 nm. The second charge transport layer 33 may transport a charge while protecting the surface of the polysilicon layer 34. The second charge transport layer 33 may be produced by a thermal evaporation, an atomic layer deposition (ALD), a rapid plasma deposition, a solution process, or the like. Through the second charge transport layer 33, the polysilicon layer 34 can be protected to reduce the damage during the subsequent thin film deposition, so as to achieve the purpose of optimizing the interface and improving the efficiency of the laminated cell.

In this disclosure, the charge transport properties of the second charge transport layer 33 can be adjusted according to the properties of the polysilicon layer 34. When the polysilicon in the polysilicon layer 34 is p-type polysilicon, the constituent material in the second charge transport layer 33 is a p-type charge transport material. When the polysilicon in the polysilicon layer is n-type polysilicon, the constituent material in the second charge transport layer is an n-type charge transport material. With such setting, the consistency of the charge transport type can be maintained, and it may be achieved to effectively transport the same type of charge and avoid recombination phenomena occurring at the interface or inside the film.

In this disclosure, the p-type charge transport material can be selected from the group consisting of NiOx (where x is between 0.1 and 10), CuFeO₂, CuAlO₂, CuSCN, Cu₂O, WO₃, CuI₂, MoS₂, FeS₂, P₃HT, Spiro-meoTAD, Poly-TBD, PFN, PEDOT:PSS, PTAA and Spiro-TTB. The n-type charge transport material is selected from the group consisting of TiO₂, SnO₂, ZnO, ZrO₂, In₂O₃, CdS, CdSe, BaSnO₃, Nb₂O₅, C60 and PCBM.

In the present disclosure, the transparent conductive layer 32 is arranged above the second charge transport layer 33. In an embodiment, the transparent conductive layer 32 is attached to the surface of the second charge transport layer 33 away from the second photoelectric conversion layer 20, and is located on the second charge transport layer 33. In an embodiment, the transparent conductive layer 32 may have a thickness of 1-1000 nm, for example 1-100 nm, such as 20 nm.

In an embodiment, the material of the transparent conductive layer 32 may be selected from the group consisting of TiO₂, SnO₂, ZnO, ZrO₂, GZO, AZO, IZO, FTO, ITO, BaSnO₃, Ti-doped SnO₂, and Zn-doped SnO₂. Preferably, it may be a material with relatively strong lateral conductivity, such as ITO, IZO, or the like. The transparent conductive layer 32 may be produced by a physical vapor deposition, a solution process, a thermal evaporation, an electron beam evaporation, or an atomic layer deposition. However, it is generally to use the physical vapor deposition.

In this disclosure, the material in the transparent conductive layer 32 is different from the material in the second charge transport layer 33. In the present disclosure, a first charge transport layer 31 is further arranged between the first photoelectric conversion layer 10 and the second photoelectric conversion layer 20. The first charge transport layer 31 is generally disposed above the transparent conductive layer 32. In an embodiment, the first charge transport layer 31 is attached to the surface of the transparent conductive layer 32 away from the second photoelectric conversion layer, and is located on the transparent conductive layer 32.

Although the first charge transport layer 31 and the second charge transport layer 33 are charge transport layers, they have different requirements in terms of the preparation method, the thickness, or the like. In the present disclosure, the first charge transport layer 31 may have a thickness of 1-500 nm, such as 1-100 nm, such as 30 nm. In an embodiment, the first charge transport layer 31 may have a thickness greater than the thickness of the second charge transport layer 33.

The first charge transport layer 31 has a charge transport property opposite to that of the second charge transport layer 33. When the constituent material of the second charge transport layer 33 is an n-type charge transport material, the constituent material in the first charge transport layer 31 is a p-type charge transport material. When the constituent material of the second charge transport layer 33 is a p-type charge transport material, the constituent material in the first charge transport layer 31 is an n-type charge transport material. In this way, it can be achieved to maintain the consistency of the current in the first and second cells, so that the type of charge transferred downward by the first cell containing the first photoelectric conversion layer is opposite to the type of charge transferred upward by the second cell containing the second photoelectric conversion layer.

In this disclosure, the p-type charge transport material may be selected from the group consisting of NiOx (where x is between 0.1 and 10), CuFeO₂, CuAlO₂, CuSCN, Cu₂O, WO₃, CuI₂, MoS₂, FeS₂, P₃HT, Spiro-meoTAD, Poly-TBD, PFN, PEDOT:PSS, PTAA, and Spiro-TTB. The n-type charge transport material may be selected from the group consisting of TiO₂, SnO₂, ZnO, ZrO₂, In₂O₃, CdS, CdSe, BaSnO₃, Nb₂O₅, C60 and PCBM.

The first charge transport layer 31 may be produced by a solution process, a thermal evaporation, a sputtering or an atomic layer deposition, or the like.

As shown in Figure 1, the solar battery may comprise the following stacked layers from a light- incident surface:
a top metal electrode 11,
a top transparent conductive layer 12,
a third charge transport layer 13,
the first photoelectric conversion layer 10,
the first charge transport layer 31,
the transparent conductive layer 32,
the second charge transport layer 33,
the polysilicon layer 34,
a tunneling layer 21,
the second photoelectric conversion layer 20,
a diffused silicon layer 22,
a passivation layer 23, and
a bottom metal electrode 24.

In the present disclosure, there may be a tunneling layer 21 between the polysilicon layer 34 and the second photoelectric conversion layer (such as a single crystal silicon layer) 20. The tunneling layer 21 may be formed by a high temperature thermal oxidation, a nitric acid oxidation, or an ozone oxidation. The tunneling layer 21 may have a thickness of 0.1 - 100 nm.

In this disclosure, a diffused silicon layer 22 may be formed on the surface of the second photoelectric conversion layer (such as, a single crystal silicon layer) 20 away from the tunneling layer 21, and may have a charge transport property opposite to that of the second photoelectric conversion layer (such as, a single crystal silicon layer) 20. In an embodiment, the second photoelectric conversion layer (such as a single crystal silicon layer) 20 is a layer of an n-type single crystal silicon, and the diffused silicon layer 22 is a layer of a p-type single crystal silicon.

A passivation layer 23 may be provided on the surface of the diffused silicon layer 22 away from the tunneling layer 21. The passivation layer 23 may have a thickness of 0.1-500 µm, and the material may include one or a combination of at least two of SiO₂, a silicon nitride, an aluminum oxide or a silicon oxynitride.

At least one bottom metal electrode 24 may be interposed on the diffused silicon layer 22. The material of the bottom metal electrode includes one or a combination of at least two of Au, Ag, Al or Cu.

Thus, the second cell containing the second photoelectric conversion layer 20 may be formed.

The third charge transport layer 13 may be formed on the first photoelectric conversion layer 10, and the third charge transport layer 13 and the first charge transport layer 31 respectively extract different types of charges from the first photoelectric conversion layer 10 and transport them to the external circuit. Therefore, the constituent material of the third charge transport layer 13 has the same charge transport property as that of the constituent material of the second charge transport layer 33, but has the charge transport property opposite to that of the constituent material of the first charge transport layer 31. When the constituent material of the second charge transport layer 33 is an n-type charge transport material, the constituent material in the third charge transport layer 13 is an n-type charge transport material. When the constituent material of the second charge transport layer 33 is a p-type When using a charge transport material, the constituent material in the third charge transport layer 13 is a p-type charge transport material.

In this disclosure, the p-type charge transport material may be selected from the group consisting of NiOx (where x is between 0.1 and 10), CuFeO₂, CuAlO₂, CuSCN, Cu₂O, WO₃, CuI₂, MoS₂, FeS₂, P₃HT, Spiro-meoTAD, Poly-TBD, PFN, PEDOT:PSS, PTAA, and Spiro-TTB. The n-type charge transport material may be selected from the group consisting of TiO₂, SnO₂, ZnO, ZrO₂, In₂O₃, CdS, CdSe, BaSnO₃, Nb₂O₅, C60 and PCBM.

The third charge transport layer 13 may have a thickness of 1-500 nm, which is greater than that of the second charge transport layer 33. The third charge transport layer 13 may be produced by a solution process, a thermal evaporation, a sputtering, an atomic layer deposition, and the like.

A top transparent conductive layer 12 may be formed on the third charge transport layer 13. In an embodiment, the top transparent conductive layer 12 may have a thickness of 0.1-1000 nm, and the material can be selected from the group consisting of TiO₂, SnO₂, ZnO, ZrO₂, GZO, AZO, IZO, FTO, ITO, BaSnO₃, Ti-doped SnO₂, and Zn-doped SnO₂. It may be produced by a sputtering, a solution process, a thermal evaporation, an electron beam thermal evaporation, or an atomic layer deposition. In general, a sputtering can be used.

At least one top metal electrode 11 may be formed on the top transparent conductive layer 12. The material of the top metal electrode may include one or a combination of at least two of Au, Ag, Al or Cu.

Thus, the first cell including the first photoelectric conversion layer may be formed.

According to needs, other layers can be arranged between the layers of the second cell and the first cell to adjust or passivate the interface and improve the efficiency of the device. For example, a buffer layer 14 may be formed between the third charge transport layer 13 and the first photoelectric conversion layer 10. The material of the buffer layer 14 may include one or a combination of at least two of molybdenum oxide, LiF, C60, SnO₂, TiO₂, SiO₂, and the like. The buffer layer may be formed by ALD, PECVD, a spin coating, a sputtering or a thermal evaporation. For another example, an anti-reflection layer (not shown) may be formed on the top transparent conductive layer 12, and the material of the anti-reflection layer may include LiF, MgF₂, Si₃N₄, SiO₂ or dimethylsiloxane polymer, etc. It may be formed by an evaporation, a sputtering or ALD.

The disclosure provides a process for preparing a solar battery, comprising:
forming a second cell comprising a second photoelectric conversion layer comprising a second photoelectric conversion material having a second bandgap;
sequentially forming a polysilicon layer, a second charge transport layer, a transparent conductive layer and a first charge transport layer on the second photoelectric conversion layer; and
forming a first cell comprising a first photoelectric conversion layer comprising a first photoelectric conversion material having a first bandgap; wherein the first bandgap is not equal to the second bandgap.

Various processes known in the art may be used to form the first cell and the second cell, as well as the layers between the second photoelectric conversion layer and the first photoelectric conversion layer such as the polysilicon layer, the first charge transport layer, and the like. However, in this disclosure, the second charge transport layer shall be formed by a mild process such as a thermal evaporation, an atomic layer deposition, a plasma rapid deposition or a solution process. In such way, the polysilicon layer may be protected during the subsequent film deposition so as to reduce the damage to the polysilicon layer, and the purpose of optimizing the interface and improving the efficiency of laminated batteries can be achieved. In an embodiment, the transparent conductive layer may be formed by a physical vapor deposition.

### Example 1

(1) An N-type single crystal silicon with a thickness of 180 µm was used as the substrate. A conventional texturing of the silicon was performed to obtain a texturing degree of 2 to 3 microns, and then hydrofluoric acid and RCA standard cleaning were performed.
(2) Phosphorus diffusion on the front side of the single crystal silicon substrate was performed in a diffusion furnace equipment to form a p-type emitter.
(3) A ultra-thin tunneling silicon dioxide layer with a thickness of 1 nm and a phosphorus-doped amorphous silicon layer were formed on back of the single crystal silicon substrate by LPCVD, and then activated at high temperature to form an n-type polysilicon with a thickness of 100 nm.
(4) A silicon nitride layer with a thickness of 75 nm was formed on the p-type emitter through PECVD equipment.
(5) An Ag electrode was formed on the p-type emitter side by a screen printing.
(6) A charge transport layer of SnO₂ with a thickness of 5 nm was formed on the n-type polysilicon by an atomic layer deposition.
(7) A transparent conductive layer of ITO with a thickness of 15 nm was deposited on the charge transport layer of SnO₂ by a magnetron sputtering.
(8) A charge transport layer of NiO with a thickness of 40 nm was deposited the layer of ITO by a magnetron sputtering.
(9) A layer of 2PACz with a thickness of 50 nm was deposited on the layer of NiO by a scrape coating.
(10) The light-absorbing layer of the perovskite Cs_{0.15}FA_{0.85}Pb(I_{0.7}Br_{0.3})₃ was prepared by a scrape coating, which had a band gap of about 1.6 9 ev and a thickness of 600 nm.
(11) A buffer layer of C₆₀ with a thickness of 5 nm was deposited on the perovskite layer by a thermal evaporation.
(12) An electron transport layer of SnO₂ with a thickness of 20 nm was deposited on the buffer layer by an atomic layer deposition.
(13) An transparent conductive layer of IZO with a thickness of 100 nm was deposited on the layer of SnO₂ by using a magnetron sputtering equipment.
(14) A metal grid line layer of Ag with a thickness of 100 nm was formed by a thermal evaporation to obtain the solar battery.

### Comparative example 1

The preparation process of the comparative example 1 was the same as that of Example 1, except that the step (6) was not included, that is, a transparent conductive layer of ITO with a thickness of 15 nm was directly deposited on the n-type polysilicon by a magnetron sputtering in step (7).

### Testing

The testing was performed as follows:
The laminated batteries prepared in Example 1 and Comparative Example 1 were placed under the AM 1.5G standard simulated sunlight with a light intensity of 100 mW/cm², to measure the current density-voltage curve of the batteries.

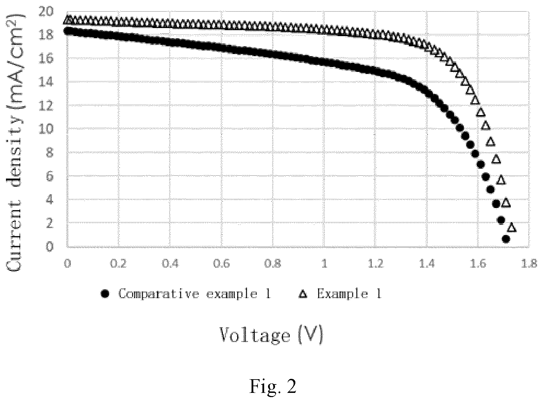

By obtaining the Open-circuit voltage (Voc), short-circuit current density (Jsc), and fill factor (FF), the photoelectric conversion efficiency (PCE) of the battery can be calculated. The results are shown in Table 1, and Fig. 2 shows the current density-voltage curves of the laminated solar batteries obtained in Example 1 and Comparative Example 1.

It can be seen that after adding the second charge transport layer SnO₂ in Example 1, all the parameters of the laminated battery have been significantly improved. For example, the photoelectric conversion efficiency has been increased from 18.71 % to 23.99 %. The increased efficiency helps the tandem cell convert more light into electricity, while also reducing the cost of the system.

**Table 1**

| | Jsc (mA/cm² ) | Voc (V) | FF (%) | PCE (%) |
|---|---|---|---|---|
| Comparative example 1 | 18.33 | 1.72 | 59.3 | 18.71 |
| Example 1 | 19.29 | 1.74 | 71.3 | 23.99 |

The present disclosure has been described above in conjunction with preferred embodiments, but these embodiments are only exemplary and serve as illustrations only. On this basis, various replacements and improvements can be made to the present disclosure, all of which fall within the protection scope of the present disclosure.

## Claims

1. A solar battery, comprising:
a first cell comprising a first photoelectric conversion layer comprising a first photoelectric conversion material having a first bandgap;
a second cell comprising a second photoelectric conversion layer comprising a second photoelectric conversion material having a second bandgap, wherein the first bandgap is not equal to the second bandgap; and
a first charge transport layer, a transparent conductive layer, a second charge transport layer and a polysilicon layer sequentially arranged between the first photoelectric conversion layer and the second photoelectric conversion layer;
wherein the second charge transport layer is disposed between the polysilicon layer and the transparent conductive layer, and the charge transport property of the second charge transport layer is the same as that of the polysilicon layer.

2. The solar battery according to claim 1, wherein
polysilicon layer is a layer of a p-type polysilicon;
the constituent material in the second charge transport layer is a p-type charge transport material; and
the constituent material in the first charge transport layer is an n-type charge transport material.

3. The solar battery according to claim 1, wherein,
the polysilicon layer is a layer of an n-type polysilicon;
the constituent material in the second charge transport layer is an n-type charge transport material; and
the constituent material in the first charge transport layer is a p-type charge transport material.

4. The solar battery according to claim 2 or 3, wherein,
the p-type charge transport material is selected from the group consisting of NiOx (where x is between 0.1 and 10), CuFeO₂, CuAlO₂, CuSCN, Cu₂O, WO₃, CuI₂, MoS₂, FeS₂, P₃HT, Spiro-meoTAD, Poly-TBD, PFN, PEDOT:PSS, PTAA and Spiro-TTB; and
the n-type charge transport material is selected from the group consisting of TiO₂, SnO₂, ZnO, ZrO₂, In₂O₃, CdS, CdSe, BaSnO₃, Nb₂O₅, C60 and PCBM.

5. The solar battery according to claim 1, wherein the first charge transport layer has a thickness which is greater than the thickness of the second charge transport layer.

6. The solar battery according to claim 1, wherein the second charge transport layer is attached to the surface of the polysilicon layer away from the second photoelectric conversion layer, and is located on the polysilicon layer; and
the transparent conductive layer is attached to the surface of the second charge transport layer away from the second photoelectric conversion layer, and is located on the second charge transport layer.

7. The solar battery according to claim 1, wherein the transparent conductive layer has a thickness of 1-1000 nm, and the material of the transparent conductive layer is selected from the group consisting of TiO₂, SnO₂, ZnO, ZrO₂, GZO, AZO, IZO, FTO, ITO, BaSnO₃, Ti-doped SnO₂, and Zn-doped SnO₂.

8. The solar battery according to claim 1, wherein the first photoelectric conversion material is selected from the group consisting of a perovskite, an amorphous silicon, GaInP, CdTe, a copper indium gallium selenide;
the second photoelectric conversion material is selected from the group consisting of a single crystal silicon, a polycrystalline silicon, GaAs, CdTe, and a perovskite.

9. The solar battery of claim 8, wherein the first photoelectric conversion material is a perovskite material with a band gap of 1.40-2.3 eV; and
the second photoelectric conversion material is single crystal silicon.

10. The solar battery according to claim 1, wherein the solar battery comprises the following stacked layers from a light- incident surface:
a top metal electrode,
a top transparent conductive layer,
a third charge transport layer,
the first photoelectric conversion layer,
the first charge transport layer,
the transparent conductive layer,
the second charge transport layer,
the polysilicon layer,
a tunneling layer,
the second photoelectric conversion layer,
a passivation layer, and
a bottom metal electrode;
wherein the constituent material of the third charge transport layer has the same charge transport property as the constituent material of the second charge transport layer.

11. The solar battery according to claim 10, wherein the third charge transport layer has a thickness greater than that of the second charge transport layer.

12. The solar battery according to claim 11, wherein the third charge transport layer has a thickness of 1-500 nm.

13. The solar battery according to claim 10, wherein the first photoelectric conversion material is a perovskite with a band gap of 1 .40-2.3 eV; and
the second photoelectric conversion material is an n-type single crystal silicon.

14. The solar battery according to claim 13, wherein the perovskite has a three-dimensional ABX₃ structure, wherein
A is selected from the group consisting of CH(NH₂)₂⁺, CH₃NH₃⁺, C(NH₂ )₃⁺, Cs⁺ and Rb⁺,
B is selected from the group consisting of Pb²⁺, Sn²⁺ and Sr²⁺, and
X is selected from the group consisting of Br⁻, I⁻ and Cl⁻.

15. The solar battery of claim 10, wherein the top transparent conductive layer has a thickness of 0.1-1000 nm, the transparent conductive layer has a thickness of 0.1-1000 nm, and the constituent material of the top transparent conductive layer and the transparent conductive layer is independently selected from the group consisting of TiO₂, SnO₂, ZnO, ZrO₂, GZO, AZO, IZO, FTO, ITO, BaSnO₃, Ti-doped SnO₂, and Zn-doped SnO₂;
the top metal electrode and the bottom metal electrode layer includes one or a combination of at least two of Au, Ag, Al or Cu;
the third charge transport layer has a thickness of 1-500 nm, the second charge transport layer has a thickness of 1-100 nm, and the constituent material of the third charge transport layer and the second charge transport layer is independently selected from the group consisting of TiO₂, SnO₂, ZnO, ZrO₂, In₂O₃, CdS, CdSe, BaSnO₃, Nb₂O₅, C60, and PCBM,
the first charge transport layer has a thickness of 1-500 nm, and the constituent material is selected from the group consisting of NiOx (where x is between 0.1 and 10), CuFeO₂, CuAlO₂, CuSCN, Cu₂O, WO₃, CuI₂, MoS₂, FeS₂, P₃HT, Spiro-meoTAD, Poly-TBD, PFN, PEDOT:PSS, PTAA, and Spiro-TTB,
the polysilicon layer has a thickness of 1 nm to 100 µm, and the material is an n-type polysilicon;
the passivation layer has a thickness of 0.1-500 µm, and the material includes one or a combination of at least two of SiO₂, silicon nitride, aluminum oxide or silicon oxynitride;
the tunneling layer has a thickness of 0.1 - 100 nm.
